Europäisches Patentamt

European Patent Office

Office européen des brevets

(19)

(11) EP 1 505 856 A2

(12) **EUROPEAN PATENT APPLICATION**

(43) Date of publication:
09.02.2005 Bulletin 2005/06

(51) Int Cl.7: **H05K 1/05**, H01L 23/14

(21) Application number: 04016472.5

(22) Date of filing: 13.07.2004

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **05.08.2003 JP 2003206101**

(71) Applicant: **Kabushiki Kaisha Toyota Jidoshokki Kariya-shi, Aichi-ken (JP)**

(72) Inventors:
• **Sugiyama, Tomohei**
 **Kariya-shi, Aichi-ken (JP)**

• **Kinoshita, Kyoichi**
 **Kariya-shi, Aichi-ken (JP)**
• **Tanaka, Katsufumi**
 **Kariya-shi, Aichi-ken (JP)**
• **Kono, Eiji**
 **Kariya-shi, Aichi-ken (JP)**

(74) Representative:
**Leson, Thomas Johannes Alois, Dipl.-Ing.**
**Tiedtke-Bühling-Kinne & Partner GbR,**
**TBK-Patent,**
**Bavariaring 4**
**80336 München (DE)**

(54) **Circuit board and semiconductor device using the same**

(57)   A base plate (1) is made of a material that is lower in thermal expansion coefficient than a wiring layer (3), to thereby set the thermal expansion coefficient of a surface of the wiring layer (3) lower than the thermal expansion coefficient of the material of the wiring layer (3). The thermal expansion coefficient of the surface of the wiring layer (3) can be set to be suitable for a semiconductor element (5) and other electronic parts mounted on the surface of the wiring layer (3), that is, set closer to the thermal expansion coefficient of the electronic parts by choosing a glass transition temperature Tg of an insulating resin layer (2) appropriately.

# FIG. 1

**Description**

BACKGROUND OF THE INVENTION:

Field of the Invention

The present invention relates to a circuit board, and more specifically to a circuit board mounted with electronic parts including a semiconductor element to be used in a semiconductor device such as a power module.

Description of the Related Art:

An example of a circuit board is disclosed in JP 06-310825 A. The circuit board according to this publication has an insulating layer and a Cu wiring layer, which are sequentially layered on a base plate formed of Al. A semiconductor element and other electronic parts are soldered to a surface of the Cu wiring layer in order to make the circuit board ready for use as a semiconductor device.

This circuit board exhibits high thermal conductivity and high dielectric strength, which are ensured by forming the insulating layer from two or more insulating resin layers different in filler content from one another.

Because the base plate of the circuit board is formed of Al having high thermal conductivity, heat generated in the electronic parts is transmitted through the Cu wiring layer and the insulating layer to the base plate and is then efficiently radiated from the base plate to the outside.

On the other hand, it is a known fact that the difference in thermal expansion coefficient between Al used to form the base plate and a semiconductor material such as Si used in the semiconductor element or other electronic parts is so large that a change in temperature of the circuit board causes thermal stress between the surface of the Cu wiring layer and the electronic parts. If the thermal stress is too great, the electronic parts might be warped and solder joining the electronic parts might be cracked.

In an attempt to ease this thermal stress, semiconductor devices for use in environments where the temperature fluctuates widely, for example, automobiles, is provided with a stress relieving member such as a heat spreader between the circuit board and the electronic parts.

However, interposing a stress relieving member causes an increase in number of parts that constitute the semiconductor device, which raises other problems including complication of the whole structure of the semiconductor device and an increase in manufacture cost.

SUMMARY OF THE INVENTION

The present invention has been made to solve the above problems, and an object of the present invention is therefore to provide a circuit board capable of, without using a stress relieving member, easing thermal stress that is generated between a wiring layer surface and electronic parts mounted to the surface.

A circuit board according to the present invention includes: a base plate; an insulating resin layer formed on a surface of the base plate; and a wiring layer formed on a surface of the insulating resin layer, the base plate being made of a material that is lower in thermal expansion coefficient than a material of the wiring layer to set the thermal expansion coefficient of a surface of the wiring layer lower than the thermal-expansion coefficient of the material of the wiring layer.

With the thermal expansion coefficient of the surface of the wiring layer set lower than that of the material of the wiring layer, the difference in thermal expansion coefficient between the wiring layer surface and electronic parts mounted on the surface is reduced and accordingly thermal stress generated between the wiring layer surface and the electronic parts is eased.

A semiconductor device according to the present invention comprises the above circuit board and electronic parts mounted on the surface of the wiring layer of the circuit board.

BRIEF DESCRIPTION OF THE DRAWINGS

Fig. 1 is a sectional view showing a semiconductor device using a circuit board according to an embodiment of the present invention;
Fig. 2 is a graph showing the thermal expansion coefficient of a wiring layer surface in relation to the thermal expansion coefficient of a base plate;
Fig. 3 is a graph showing the thermal expansion coefficient of the wiring layer surface in relation to a change in temperature of the surroundings; and
Fig. 4 is a graph showing the thermal expansion coefficient of the wiring layer surface in relation to the thickness of an insulating resin layer.

DETAILED DESCRIPTION OF THE PREFERRED EMBODIMENT

An embodiment of the present invention will be described below with reference to the accompanying drawings.

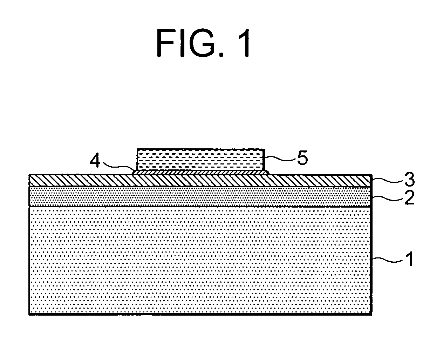

Fig. 1 shows the section of a circuit board according to this embodiment, on which a semiconductor element is mounted. The circuit board is comprises a base plate 1 made of an Al/SiC composite material, an insulating resin layer 2 formed on a surface of the base plate 1, and a wiring layer 3 made of Cu and formed on the insulating resin layer 2. A semiconductor element 5 as one of electronic parts is bonded to a surface of the wiring layer 3 with a solder 4 to make the circuit board ready for use as a semiconductor device.

The base plate 1 is made of the Al/SiC composite material which is obtained by pouring a melt of Al or a melt of an Al alloy containing Si into a mold filled with SiC powder and then casting to have a thermal expansion coefficient of $8.4 \times 10^{-6}$ /K. The insulating resin layer 2 is made of epoxy-based resin containing filler and having a glass transition temperature Tg of, for example, 152°C. The thermal expansion coefficient of Cu used to form the wiring layer 3 is $17.5 \times 10^{-6}$ /K, which makes the base plate 1 lower in thermal expansion coefficient than the wiring layer 3. The base plate 1 is 3 mm in thickness, the insulating resin layer 2 is 100 μm in thickness, and the wiring layer 3 is 100 μm in thickness.

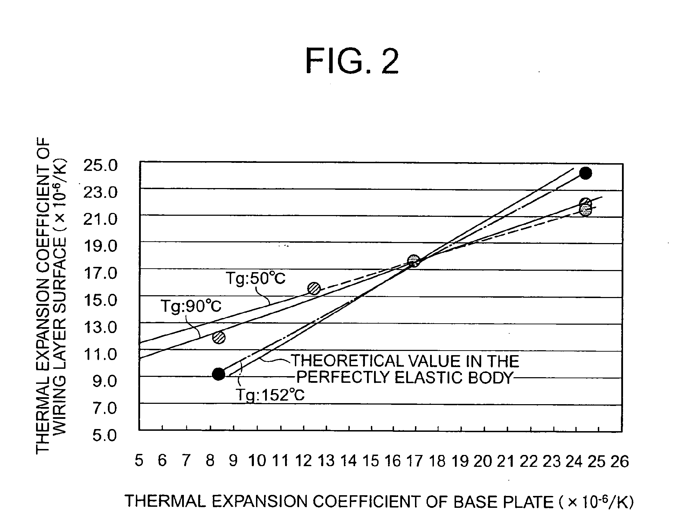

It has been understood from a measurement with a strain gauge that the thermal expansion coefficient of a surface of the wiring layer 3 is about $9.2 \times 10^{-6}$ /K, and is lower than the thermal expansion coefficient of Cu constituting the wiring layer 3 ($17.5 \times 10^{-6}$ /K). Fig. 2 shows the results of measuring with a strain gauge the thermal expansion coefficient of the surface of the wiring layer 3 in each of circuit board samples whose base plates are different from one another in thermal expansion coefficient.

It is understood from Fig. 2 that the thermal expansion coefficient of the surface of the wiring layer 3 is lower than that of the material forming the wiring layer 3 when the thermal expansion coefficient of the base plate 1 is lower than $17.5 \times 10^{-6}$ /K, which is the thermal expansion coefficient of Cu forming the wiring layer 3. Fig. 2 further indicates that, in the case where the base plate 1 is lower in thermal expansion coefficient than the wiring layer 3, the higher the glass transition temperature Tg of the insulating resin layer 2 is set, the lower the thermal expansion coefficient of the surface of the wiring layer 3 descends toward the theoretical value on assuming that the insulating resin layer 2 is a perfectly elastic body.

For instance, when the base plate 1 is made of anAl/SiC composite material that has a thermal expansion coefficient of $8.4 \times 10^{-6}$ /K, a thermal expansion coefficient of the surface of the wiring layer 3 is about $13 \times 10^{-6}$ /K by setting the glass transition temperature Tg of the insulating resin layer 2 to 50°C, about $12 \times 10^{-6}$ /K by setting the glass transition temperature Tg of the insulating resin layer 2 to 90°C, and about $9 \times 10^{-6}$ /K by setting the glass transition temperature Tg of the insulating resin layer 2 to 152°C. Therefore, the thermal expansion coefficient of the surface of the wiring layer 3 can be set between $9 \times 10^{-6}$ /K and $13 \times 10^{-6}$ /K by choosing as the insulating resin layer 2 that has the glass transition temperature Tg of 50°C to 152°C.

As described above, the thermal expansion coefficient of the surface of the wiring layer 3 can be set lower than the thermal expansion coefficient of the material of the wiring layer 3 by forming the base plate 1 from a material that is lower in thermal expansion coefficient than the wiring layer 3. Of various electronic parts such as the semiconductor element 5 mounted on the surface of the wiring layer 3, a chip resistor, a chip capacitor, and an Si semiconductor circuit chip, for example, have thermal expansion coefficients of about $7 \times 10^{-6}$ /K, $10 \times 10^{-6}$ /K, and $2.6 \times 10^{-6}$ /K, respectively. Setting the thermal expansion coefficient of the surface of the wiring layer 3 lower than $17.5 \times 10^{-6}$ /K, which is the thermal expansion coefficient of the material of the wiring layer 3, makes it possible to prevent, without using any stress relieving member, generation of a large thermal stress between the surface of the wiring layer 3 of the circuit board and the electronic parts including the semiconductor element 5 caused by a temperature change. Obtained as a result is a highly reliable semiconductor device which has no fear of warping the semiconductor element 5 or cracking the solder 4 even when used in automobiles and like other environments where the temperature fluctuates widely. In short, the solder reliability in a thermal shock cycle is improved. Another effect of eliminating the need for a heat spreader is a reduction in number of parts, which leads to simplification of the semiconductor device structure, fewer assembling steps, and less cost.

If resin having a specific glass transition temperature Tg is chosen for the insulating resin layer 2, the thermal expansion coefficient of the surface of the wiring layer 3 can be adjusted to suit the thermal expansion coefficient of the semiconductor element 5 and other electronic parts mounted to the surface of the wiring layer 3 without changing the material of the base plate 1. In other words, by setting the thermal expansion coefficient of the surface of the wiring layer 3 closer to the thermal expansion coefficient of the semiconductor element 5 mounted thereon, thermal stress generated between the surface of the wiring layer 3 and the semiconductor element 5 as one of electronic parts mounted on the surface of the wiring layer 3 can be eased more efficiently.

Furthermore, the circuit board can have excellent heat radiation characteristics if the base plate 1 is formed from an Al/SiC composite material that has as high thermal conductivity as pure Al. In addition, since no stress relieving member such as a heat spreader is needed, the overall heat resistance of the semiconductor device that is obtained by mounting the semiconductor element 5 and other electronic parts to the circuit board can be reduced.

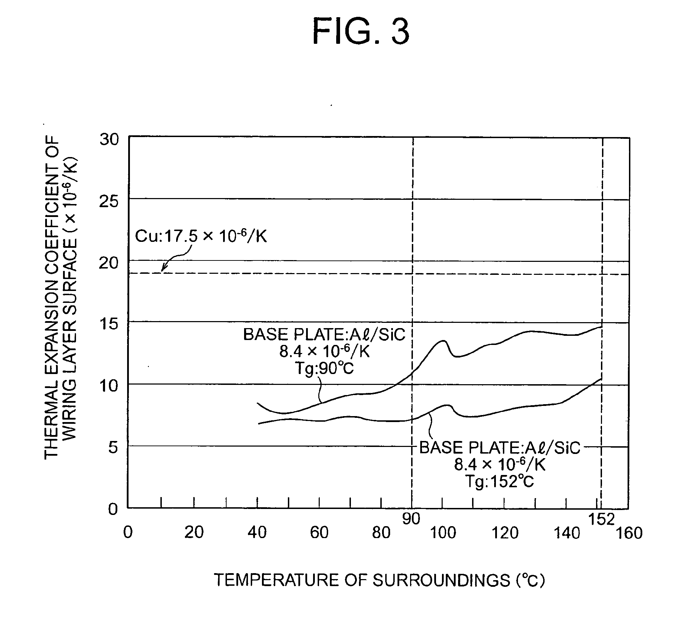

Fig. 3 shows how the thermal expansion coefficient of the surface of the wiring layer 3 is changed by a change in temperature of the surroundings of the circuit board. When the base plate 1 is formed from anAl/SiC compositematerial having a thermal expansion coefficient of $8.4 \times 10^{-6}$ /K while the glass transition temperature Tg of the insulating resin layer 2 is 90°C, the thermal expansion coefficient of the surface of the wiring layer 3 is gradually raised as the temperature of the surroundings approaches 90°C, which is the glass transition temperature Tg of the insulating resin layer 2. After the temperature of the surroundings exceeds Tg, the thermal expansion coefficient of the surface of the wiring layer 3 is rapidly increased toward $17.5 \times 10^{-6}$ /K, which is the thermal expansion coefficient of the material of the wiring layer 3. Further, also in the case where the glass transition temperature Tg of the insulating resin layer 2 is changed to 152°C while the base plate 1 is formed from the same material as above, the thermal expansion coefficient of the surface of the wiring layer 3 is gradually raised as the temperature of the surroundings approaches the glass transition temperature Tg of the insulating resin layer 2, namely, 152°C, and it is presumed that the thermal expansion coefficient of the surface of the wiring layer 3 is then increased rapidly after the temperature of the surroundings exceeds Tg.

Since the thermal expansion coefficient of the surface of the wiring layer 3 starts a rise at a point near the glass transition temperature Tg of the insulating resin layer 2 and continues to rise toward the thermal expansion coefficient of the material of the wiring layer 3 as the temperature of the surrounding is raised, it is preferable to set the glass transition temperature Tg of the insulating resin layer 2 higher than the upper limit of the temperature range in which the circuit board can be used. In automobiles, the temperature range in which a circuit board can be put into use is generally between -40°C and 125°C or between -55°C and 150°C. Therefore, the glass transition temperature Tg of the insulating resin layer 2 is preferably set to 152°C, for example.

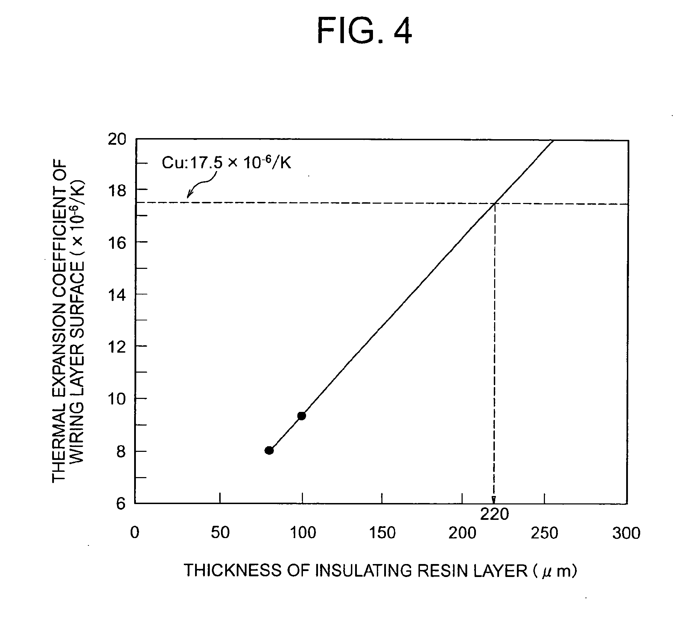

Fig. 4 shows a change in thermal expansion coefficient of the surface of the wiring layer 3 in relation to the thickness of the insulating resin layer 2 when the base plate 1 is made of an Al/SiC composite material having a thermal expansion coefficient of $8.4 \times 10^{-6}$ /K while the glass transition temperature Tg of the insulating resin layer 2 is set to 152°C. It is understood from Fig. 4 that the thermal expansion coefficient of the surface of the wiring layer 3 is lowered as the thickness of the insulating resin layer 2 is reduced. The relation between a thickness Dp (μm) of the insulating resin layer 2 and a thermal expansion coefficient βs (x $10^{-6}$ /K) of the surface of the wiring layer 3 is expressed as follows:

$$\beta s = 0.0686 \cdot Dp + 2.3578$$

As shown in Fig. 4, the thickness Dp of the insulating resin layer 2 is preferably about 20 μm to 220 μm in this circuit board since setting the thickness Dp of the insulating resin layer 2 to 220 μm makes the thermal expansion coefficient βs of the surface of the wiring layer 3 approximately equal to $17.5 \times 10^{-6}$ /K, which is the thermal expansion coefficient of the material of the wiring layer 3.

The result of an experiment proves that the thermal expansion coefficient of the surface of the wiring layer 3, namely, the thermal expansion coefficient βs (x $10^{-6}$ /K) of the portion to which the semiconductor element 5 is mounted is expressed as follows when βs < $17.5 \times 10^{-6}$ /K is satisfied:

$$\beta s = -0.044 \cdot Tg + 0.07 \cdot Dp + 0.878 \cdot \beta b - 0.3 \cdot Db$$

wherein Tg (°C) represents the glass transition temperature of the insulating resin layer 2, Dp (μm) represents the thickness of the insulating resin layer 2, Db (mm) represents the thickness of the base plate 1, and βb (x $10^{-6}$ /K) represents the thermal expansion coefficient of the base plate 1.

The expression shows that the thermal expansion coefficient βs of the surface of the wiring layer 3 is lowered by increasing the glass transition temperature Tg of the insulating resin layer 2 or by reducing the thickness Dp of the insulating resin layer 2.

Although the wiring layer 3 is made of Cu in the embodiment described above, it may be formed of Al or Ni instead.

The material of the base plate 1 is not limited to an Al/SiC composite material having a thermal expansion coefficient of $8.4 \times 10^{-6}$ /K, and can be any other material as long as the thermal expansion coefficient of the base plate 1 is lower than the thermal expansion coefficient of the wiring layer 3.

As has been described, according to the present invention, a circuit board has a base plate, an insulating resin layer formed on a surface of the base plate, and a wiring layer formed on a surface of the insulating resin layer, and the thermal expansion coefficient of a surface of the wiring layer is set lower than the thermal expansion coefficient of the material of the wiring layer by employing a base plate material that is lower in thermal expansion coefficient than the material of the wiring layer, thus making it possible to ease, without the use of a stress relieving member, thermal stress generated between the surface of the wiring layer and electronic parts mounted on the wiring layer surface.

A base plate is made of a material that is lower in thermal expansion coefficient than a wiring layer, to thereby set the thermal expansion coefficient of a surface of the wiring layer lower than the thermal expansion coefficient of the material of the wiring layer. The thermal expansion coefficient of the surface of the wiring layer can be set to be suitable for a semiconductor element and other electronic parts mounted on the surface of the wiring layer, that is, set closer to the thermal expansion coefficient of the electronic parts by choosing a glass transition temperature Tg of an insulating resin layer appropriately.

**Claims**

1.  A circuit board comprising:

    a base plate;
    an insulating resin layer formed on a surface of the base plate; and
    a wiring layer formed on a surface of the insulating resin layer,

    the base plate being made of a material that is lower in thermal expansion coefficient than a material of the wiring layer to set a thermal expansion coefficient of a surface of the wiring layer lower than a thermal expansion coefficient of the material of the wiring layer.

2.  A circuit board according to claim 1, wherein the insulating resin layer has a glass transition temperature corresponding to a thermal expansion coefficient of electronic parts to be mounted on the surface of the wiring layer.

3.  A circuit board according to claim 1, wherein the base plate is made of an Al/SiC composite material obtained by pouring a melt of Al or a melt of an Al alloy containing Si into a mold filled with SiC powder and then casting to have a thermal expansion coefficient of $6 \times 10^{-6}$ /K to $12 \times 10^{-6}$ /K.

4.  A circuit board according to claim 1, wherein a glass transition temperature of the insulating resin layer is higher than an upper limit of a temperature range in which the circuit board can be used.

5.  A circuit board according to claim 4, wherein the circuit board is used in automobiles, the glass transition temperature of the insulating resin layer being $150°C$ or higher.

6.  A circuit board according to claim 5, wherein a thickness of the insulating resin layer is set to approximately 20 $\mu$m to 220 $\mu$m.

7.  A semiconductor device comprising:

    a circuit board according to claim 1; and
    electronic parts mounted on a surface of the wiring layer of the circuit board.

# FIG. 1

# FIG. 2

# FIG. 3

# FIG. 4